Europäisches Patentamt

European Patent Office

Office européen des brevets

(11) Numéro de publication: **0 131 737**
**A1**

## DEMANDE DE BREVET EUROPEEN

(21) Numéro de dépôt: **84106516.2**

(22) Date de dépôt: **07.06.84**

(51) Int. Cl.⁴: **H 01 R 4/04**
**H 05 K 3/32**

(30) Priorité: **15.06.83 FR 8310015**

(43) Date de publication de la demande:
**23.01.85 Bulletin 85/4**

(84) Etats contractants désignés:
**CH DE GB LI NL**

(71) Demandeur: ASULAB S.A.
Faubourg du Lac 6
CH-2501 Bienne(CH)

(72) Inventeur: Cognard, Jacques
Rue du Suchiez 53
CH-2006 Neuchâtel(CH)

(72) Inventeur: Ganguillet, Claude
Avenue des Alpes 22
CH-2000 Neuchâtel(CH)

(74) Mandataire: de Montmollin, Henri et al,
c/o ASUAG - Société Générale de l'Horlogerie Suisse S.A.
6, Faubourg du Lac
CH-2501 Bienne(CH)

(54) Procédé de connexion de deux conducteurs.

(57) Le procédé pour connector les conducteurs (4, 6) consiste à déposer sur un des conducteurs (4) une couche de matériau adhésif non conducteur (9), à disposer le deuxième conducteur (6) en regard du premier conducteur (4), et à rapprocher les conducteurs (4, 6) l'un de l'autre alors que le matériau adhésif (9) est dans son état liquide ou pâteux jusqu'à ce que l'épaisseur de la couche prenne une valeur pour laquelle le matériau adhésif (9) est électriquement conducteur dans son état solide.

L'invention s'applique à tous les domaines de la technique où des conducteurs doivent être reliés électriquement.

EP 0 131 737 A1

Croydon Printing Company Ltd

0131737

Cas 312-EP

HM/ek/g

## PROCEDE DE CONNEXION DE DEUX CONDUCTEURS

La présente invention a pour objet un procédé pour connecter électriquement un premier et un deuxième conducteur.

Les dispositifs électriques et/ou électroniques comportent un certain nombre de composants tels que des transitors, des diodes, des circuits intégrés, des résistances, des condensateurs, des piles, des dispositifs d'affichage, etc. Ces composants sont munis d'éléments de liaison électrique sous la forme de fils, de bornes, de plages de contact, etc. Les éléments de liaison des divers composants sont souvent reliés électriquement les uns aux autres, au moins en partie, par un circuit imprimé, c'est-à-dire un substrat isolant, souple ou rigide, sur lequel sont disposées des pistes conductrices. Tous ces éléments de liaison ainsi que les pistes de circuit imprimé seront désignés simplement par le terme de "conducteur" dans la suite de cette description.

Il existe de très nombreux procédés pour connecter électriquement deux conducteurs. Parmi ceux-ci, un des plus utilisés est le procédé de soudure des conducteurs, qui peut être une soudure à chaud avec ou sans apport de matériau fusible, ou une soudure à froid.

Le collage des conducteurs à l'aide d'un adhésif rendu conducteur par adjonction d'une poudre métallique est également très souvent utilisé.

D'autres procédés sont particulièrement adaptés à la connexion électrique de conducteurs de très petites dimensions, par exemple les plages de contact d'un circuit intégré et les pistes correspondantes d'un circuit imprimé.

Dans ces procédés, des conducteurs intermédiaires en forme de fils très fins ou de languettes sont utilisés. Les extrêmités de chacun de ces conducteurs intermédiaires sont reliées par thermo-compression l'une directement à une des plages de contact du circuit intégré et l'autre à la piste correspondante du circuit imprimé. Ces procédés, qui ne seront pas décrits plus en détail ici car ils sont bien connus, sont souvent désignés par leur nom anglais de "wire-bonding" et de "gang-bonding".

Un autre procédé utilisé pour la connexion d'un circuit intégré et d'un circuit imprimé consiste à découper une ouverture dans le substrat du circuit imprimé de manière à dégager une extrêmité de certaines des pistes conductrices, et à relier, également par thermo-compression, chacune de ces extrêmités directement à un pied de contact formé par galvano-plastie sur une des plages de contact du circuit intégré. Ce procédé, qui ne sera pas non plus décrit en détail ici, est généralement désigné par son nom anglais de "Tape Automated Bonding" ou "TAB".

La connexion électrique des conducteurs entre eux suffit parfois à assurer leur fixation mécanique ainsi que celle des composants dont ils font partie. Dans de nombreux cas, il est cependant nécessaire de fixer mécaniquement les composants soit au circuit imprimé soit à un chassis ou à un autre support à l'aide d'éléments spécialement prévus à cet effet.

Les divers procédés connus de connexion électrique de deux conducteurs présentent tous divers inconvénients.

Les conducteurs destinés à être reliés par soudage, par exemple, doivent en général être spécialement préparés en les recouvrant de couches de protection contre la corrosion et/ou d'amélioration de leur soudabilité. Des produits décapants doivent en outre être utilisés juste avant ou pendant l'opération de soudage pour enlever toute trace d'oxyde sur les conducteurs. Ces produits décapants doivent ensuite être soigneusement éliminés par diverses opérations de lavage.

Les adhésifs conducteurs sont chers car la poudre de métal qui leur est ajoutée pour les rendre conducteurs est en général une poudre d'or ou d'argent. Ils présentent en outre généralement une faible résistance mécanique, ce qui implique que les divers conducteurs qu'ils relient électriquement doivent être fixés mécaniquement par d'autres moyens. En outre, si les conducteurs d'un composant sont très proches les uns des autres, ce qui est souvent le cas, le dépôt de ces adhésifs conducteurs doit être réalisé en évitant d'en mettre entre ces conducteurs, pour éviter des court-circuits intempestifs.

Tous les procédés utilisant la thermo-compression sont complexes et nécessitent l'emploi de machines automatiques d'un prix très élevé. En outre, les circuits intégrés destinés à être connectés à un circuit imprimé à l'aide du procédé de "Tape Automated Bonding" sont plus chers que les circuits intégrés ordinaires. Ils doivent en effet être munis des pieds de contact nécessaires dans ce procédé, qui doivent être déposés sur les plages de contact par galvano-plastie. Ce dépôt par galvano-plastie coûte assez cher et implique, en plus, une augmentation de l'épaisseur de la couche isolante, généralement en verre, qui protège la plaquette de silicium constituant le circuit intégré proprement dit. Cette couche isolante, qui a normalement une épaisseur d'environ 5 micromètres, doit avoir dans ce cas une épaisseur de 25 micromètres au moins, pour que la plaquette de silicium ne soit pas contaminée pendant l'opération de galvano-plastie.

Le but de la présente invention est de proposer un procédé de connexion qui ne présente pas les inconvénients des procédés connus, qui soit meilleur marché que ceux-ci et qui permette dans la plupart des cas de renoncer à des moyens de liaison mécanique particuliers des conducteurs.

Ce but est atteint par le procédé revendiqué qui consiste à déposer sur au moins un des deux conducteurs une couche d'un matériau adhésif non conducteur, à disposer le deuxième conducteur contre cette couche de matériau adhésif en regard du premier conducteur, et à rapprocher les conducteurs l'un de l'autre alors que le matériau adhésif est dans son état liquide ou pâteux jusqu'à ce que l'épaisseur de la couche prenne une valeur pour laquelle le matériau adhésif est électriquement conducteur dans son état solide.

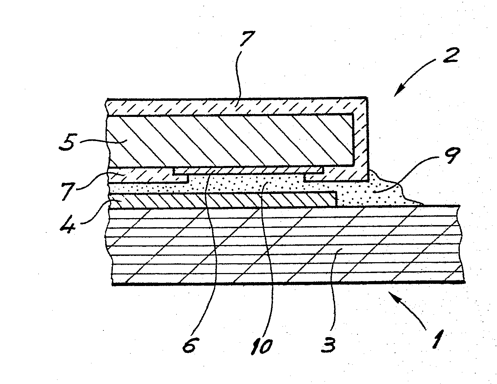

L'invention va maintenant être décrite à l'aide du dessin dans lequel la figure unique représente schématiquement et en coupe un circuit intégré qui a été relié à un circuit imprimé en utilisant le procédé selon l'invention.

L'assemblage représenté en coupe schématique par la figure, à titre d'exemple non limitatif, comporte un circuit imprimé 1 et un circuit intégré 2.

Le circuit imprimé 1 comprend, de manière classique, un substrat isolant 3 portant des pistes conductrices en cuivre. Une de ces pistes est désignée par la référence 4.

Le circuit intégré 2 comporte, de manière également classique, une plaquette de silicium 5 dans laquelle sont intégrés, de manière bien connue, de nombreux composants électroniques, principalement des transistors.

Un réseau de conducteurs métalliques est disposé sur l'une des faces de la plaquette de silicium 5. Ce réseau est destiné à relier entre eux et/ou avec l'extérieur divers points du circuit électronique. Ce réseau forme, à certains endroits convenablement choisis, des plages de contact. Une de ces plages est représentée avec la référence 6.

La plaquette de silicium 5 est enrobée dans une couche de protection 7, généralement en verre, qui comporte des ouvertures situées au droit des plages de contact telles que 6.

Pour réaliser l'assemblage représenté par la figure, une première variante du procédé selon l'invention consiste à déposer tout d'abord sur les conducteurs tels que 4 du circuit imprimé 1 une couche 9 d'un adhésif ordinaire, sans adjonction de poudre métallique et donc isolant, alors que cet adhésif est dans un état non solide, c'est-à-dire selon les cas liquide ou pâteux.

Pour de nombreux matériaux adhésifs, cet état liquide ou pâteux est celui dans lequel ils sont fournis par leur fabricant, ou dans lequel ils se présentent immédiatement après le mélange de leurs composants. C'est le cas notamment des adhésifs qui sont rangés par la norme DIN 16920 (DIN = Deutsches Institut für Normung, Berlin) dans la classe des adhésifs de réaction. Cette classe des adhésifs de réaction comporte, entre autres, les adhésifs à base de résine époxyde, de polyuréthane ou de phénolformaldéhyde.

Ces matériaux adhésifs peuvent donc être déposés sur le circuit imprimé 1 sans autre préparation.

D'autres matériaux adhésifs se présentent normalement à l'état solide. C'est le cas notamment des adhésifs rangés par la norme DIN 16920 dans de la classe des adhésifs thermo-fusibles dont font partie, entre autres, les adhésifs à base de polyamide, de polyester ou d'éthyl-vinyl-acétate.

Pour pouvoir être utilisés dans cette première variante du procédé selon l'invention, les matériaux faisant partie de cette classe des adhésifs thermo-fusibles doivent donc être rendus liquides par chauffage à la température prescrite par leur fabricant avant d'être déposés sur le circuit imprimé.

Le circuit intégré 2 est ensuite appliqué contre la couche d'adhésif 9, alors que celui-ci est encore dans son état liquide ou pâteux, de manière que chaque plage de contact telle que 6 soit située en regard du conducteur tel que 4 correspondant.

Si le matériau adhésif 9 est suffisamment fluide, le circuit intégré 2 s'enfonce alors pratiquement de lui-même dans la couche de matériau adhésif 9, jusqu'à ce que sa face inférieure se trouve presque en contact avec les pistes conductrices telles que 4. Le matériau adhésif 9 remplit les ouvertures ménagées dans la couche isolante 7 et vient au contact des plages de contact telles que 6.

La couche isolante 7 ayant une épaisseur de 5 micromètres environ, les plages de contact telles que 6 sont donc reliées aux pistes conductrices telles que 4 par une couche de matériau adhésif ayant pratiquement la même épaisseur. La zone située entre la plage de contact 6 et la piste conductrice correspondante 4 est désignée par la référence 10.

Si l'adhésif utilisé fait partie de la classe des adhésifs thermo-fusibles, et qu'il s'est resolidifié en se refroidissant après son dépôt, il faut bien entendu, dans cette première variante, le chauffer à nouveau pour qu'il reprenne son état liquide, juste avant de mettre en place le circuit intégré 2.

Le matériau adhésif formant la couche 9 est ensuite durci, en soumettant l'ensemble constitué du circuit imprimé 1, du circuit intégré 2 et de la couche de matériau adhésif 9 au traitement prescrit par le fabricant de ce matériau adhésif.

Dans le cas d'un adhésif thermo-fusible, ce traitement consiste simplement à le laisser se refroidir. Pour d'autres adhésifs, tels que les résines époxydes par exemple, ce durcissement résulte d'une polymérisation qui peut se produire également à froid, ou bien qui nécessite un chauffage jusqu'à une température déterminée. D'autres adhésifs, tels que les esters cyanoacryliques, doivent être soumis à une certaine pression pour durcir.

Une deuxième variante du procédé est utilisable avec les adhésifs thermo-fusibles. Dans cette deuxième variante, le matériau adhésif thermo-fusible est déposé sur les conducteurs tels que 4 alors qu'il est dans sa forme solide, c'est-à-dire sans chauffage préliminaire. Un tel matériau peut par exemple se présenter sous la forme d'une feuille mince qui peut être découpée aux dimensions voulues.

Le circuit intégré 2 est ensuite posé sur le matériau adhésif, toujours sous sa forme solide, de manière que les plages de contact telles que 6 soient situées, chacune, en regard de la piste conductrice 4 correspondante.

Le matériau thermo-fusible est ensuite chauffé jusqu'à ce qu'il prenne son état liquide, en mettant par exemple l'ensemble ainsi formé dans un four.

Comme dans le première variante du procédé, le circuit intégré 2 s'enfonce alors dans le matériau adhésif, jusqu'à ce qu'il se trouve à faible distance des pistes conductrices 4. L'ensemble est ensuite refroidi, et le matériau adhésif reprend donc son état solide.

La déposante a constaté que si les deux conducteurs, constitués dans l'exemple décrit par la piste 4 et la plage de contact 6, sont suffisamment rapprochés, c'est à dire si l'épaisseur de la couche de matériau adhésif qui les sépare est suffisamment faible, ce matériau adhésif est électriquement conducteur dans son état solide, et les deux conducteurs sont connectés électriquement.

Dans un assemblage tel que celui de figure, il n'est pratiquement pas possible de mesurer directement la résistance électrique de la couche de matériau adhésif située dans les zones telles que 10, entre les plages de contact telles que 6 et les pistes conductrices telles que 4. Ces zones ne sont en effet pas accessibles après l'assemblage du circuit intégré 2 sur le circuit imprimé 1.

Une estimation de la valeur de cette résistance peut cependant être faite de la manière suivante:

Les caractéristiques électriques d'un certain nombre de circuits intégrés de différents types connectés à un circuit imprimé à l'aide du procédé selon l'invention sont mesurées à partir des extrémités libres des pistes de ce circuit imprimé.

L'épaisseur de l'adhésif dans les zones telles que la zone 10 est calculée en déduisant de l'épaisseur totale de l'assemblage la somme de l'épaisseur du circuit intégré entre sa face supérieure et la plage de contact 6 et de l'épaisseur du circuit imprimé, mesurées préalablement.

Les caractéristiques mesurées ci-dessus sont ensuite comparées avec celles de circuits intégrés des mêmes types reliés à un circuit imprimé par un procédé classique.

Cette comparaison montre que la résistance électrique d'une couche d'adhésif telle que 10 ne dépasse pas quelques ohms si son épaisseur est inférieure à une valeur qui dépend de l'adhésif utilisé.

Il faut noter que la résistivité d'un matériau adhésif, mesurée dans les conditions habituelles, est de plusieurs dizaines, voire même de plusieurs centaines de Megohm.cm. Selon la relation bien connue

$$R = \frac{\rho \cdot l}{S}$$

qui permet de calculer la résistance R d'un objet quelconque en fonction de sa résistivité $\rho$, de sa longueur l et de sa section S, la résistance d'une couche de matériau adhésif devrait avoir une valeur beaucoup plus élevée que celle qui est mesurée de la manière décrite ci-desus. En effet, en prenant par exemple pour la résistivité du matériau adhésif une valeur de 10 Meghom.cm, ce qui est une valeur assez faible, pour l'épaisseur de la couche une valeur de 1 micromètre, soit $10^{-4}$cm, et pour la section de la couche à travers laquelle passe le courant une valeur de 0,1 . 0,1mm$^2$, soit cm$^2$, la résistance Rc de la couche d'adhésif calculée selon la relation ci-dessus devrait être

$$Rc = \frac{10 \text{ Megohm.cm} \times 10^{-4} \text{ cm}}{10^{-4} \text{cm}^2} = 10 \text{ Megohms}$$

Si l'épaisseur de la couche d'adhésif était de 5 micromètres, par exemple, sa résistance devrait alors être de 50 Meghoms.

Or, les mesures décrites ci-dessus montrent que la résistance réelle de la couche d'adhésif est souvent inférieure à un dixième d'ohm et ne dépasse généralement pas quelques ohms, même si l'épaisseur de la couche d'adhésif atteint 10 ou 20 micromètres.

La déposante a également constaté que, dans un assemblage tel que celui de la figure, les pistes conductrices adjacentes ne sont pas court-circuitées, bien que la couche de matériau adhésif recouvre également l'espace qui les sépare et qui mesure environ 0,1mm. La résistance électrique du matériau adhésif entre ces pistes a des valeurs généralement plusieurs fois supérieures à 10 Megohms.

La déposante a constaté que la résistance électrique de n'importe quel adhésif a une valeur très élevée lorsque son épaisseur est supérieure à 50 micromètres. Pour des épaisseurs inférieures, cette résistance électrique dépend de la nature de l'adhésif utilisé.

Cette propriété des matériaux adhésifs d'avoir une résistivité qui diminue fortement avec leur épaisseur rend le procédé selon l'invention très intéressant pour le montage et la connexion électrique d'un ou de plusieurs circuits intégrés sur un circuit imprimé. Le matériau adhésif peut en effet être déposé sur toute la partie du circuit imprimé destinée à recevoir le ou les circuits intégrés, en une couche continue qui recouvre aussi bien les pistes conductrices que les espaces qui les séparent. Après mise en place du ou des circuits intégrés et durcissement de l'adhésif, chaque plage de contact est reliée électriquement à la piste conductrice correspondante sans qu'il y ait de court-circuit entre les pistes voisines.

Il faut noter que, dans la plupart des cas, l'adhésif est assez fluide dans sa forme non solide. Le simple fait de poser le circuit intégré sur la couche de matériau adhésif et de la maintenir en place pendant le durcissement de cet adhésif suffit à rapprocher suffisamment les plages de contact telles que 6 des pistes conductrices telles que 4 pour que l'épaisseur de cette couche dans les zones telles que 10 prenne une valeur pour laquelle le matériau ahésif est électriquement conducteur dans son état solide.

Dans certains cas toutefois, notamment lorsque la viscosité de l'adhésif utilisé est élevée, il peut être nécessaire d'exercer une certaine pression sur le circuit intégré 2 pour que l'épaisseur de la couche 10 prenne cette valeur.

Il est évident que le procédé décrit ci-dessus ne se limite pas au montage et à la connexion d'un circuit intégré sur un circuit imprimé. Il peut être appliqué avantageusement au montage et à la connexion sur un circuit imprimé de cellules d'affichage électro-chromiques ou à cristal liquide, ou de n'importe quel autre genre de composants. Il peut être également appliqué sans difficulté à la liaison électrique de deux conducteurs quelconques.

Il est également évident que le procédé selon l'invention ne se limite pas au cas où la couche d'ahésif est disposée sur un seul des conducteurs. Il serait bien entendu possible de disposer une couche d'adhésif sur chacun des conducteurs avant que ceux-ci ne soient présentés l'un en face de l'autre.

La déposante a encore constaté que l'état de surface des conducteurs avant leur liaison à l'aide du procédé selon l'invention n'a pratiquement pas d'effet sur la résistance électrique de la couche de matériau adhésif dans son état durci. Ces conducteurs ne doivent donc pas être traités spécialement avant leur liaison, et aucune opération de nettoyage n'est nécessaire après celle-ci.

Le procédé selon l'invention a en outre l'avantage que les divers éléments de l'assemblage sont liés mécaniquement les uns aux autres par le matériau adhésif, ce qui permet dans bien des cas de renoncer à prévoir des éléments de fixation mécanique particuliers. Enfin, le prix du matériau adhésif n'est pas augmenté par une adjonction de poudre métallique.

Le procédé selon l'invention a encore l'avantage indirect de permettre d'utiliser des circuits intégrés normaux, sans pied de contact, dans le procédé de "Tape Automated Bonding".

Les résultats obtenus avec des assemblages tels que celui de la figure ont été confirmés par une série d'expériences au cours desquelles le procédé selon l'invention a été utilisé pour relier des conducteurs de diverses natures à l'aide de divers matériaux adhésifs du commerce.

Pour éviter des répétitions inutiles, les adhésifs utilisés pour réaliser ces expériences sont mentionnés dans la liste suivante avec leur nom commercial ou celui de leurs composants, leur fournisseur et les conditions dans lesquelles ils sont employés.

La classification de ces adhésifs a été faite conformément à la norme DIN 16920, édition de juin 1981.

A)  Adhésifs de réaction

1.  Engelhardt 46-12.

Genre: Phénoplaste.

Fournisseur: Engelhardt Sale Ltd, Clinderford, Gloucester, Grande-Bretagne

Durcissement par chauffage à 80°C pendant 30 minutes, puis à 170° C pendant 30 minutes.

2.  Cyanolite 401.

Genre: Ester cyanoacrylique.

Fournisseur: 3M (Suisse) SA, Zürich, Suisse

Durcissement par pression pendant 10 à 20 secondes.

3.  Fana PUR 1.

Genre: Polyisocyanate + polyol.

Fournisseur: Chemische Fabrik Neuallschwil AG, Allschwil, Suisse.

Durcissement par chauffage à 20°C pendant 10 à 12 heures ou à 40°C pendant 4 heures.

4.  828 EL + HY 951.

Genre: Résine époxyde + polyamine.

Mélange de résine époxyde 828 EL et de durcisseur HY 951 dans la proportion de 100 à 7 ou 8 en poids.

Fournisseur de la résine 828 EL: Shell (Suisse), Zürich, Suisse.

Fournisseur du durcisseur HY 951: Ciba-Geigy AG, Bâle, Suisse.

Durcissement par chauffage à 60°C pendant 2 heures.

5. AV 118.

   Genre: Résine époxyde + polyamine.

   Fournisseur: Ciba-Geigy AG, Bâle, Suisse.

   Durcissement par chauffage à 125°C pendant 1 heure.

6. EC 1386.

   Genre: Résine époxyde + polyamine.

   Fournisseur: 3M (Suisse) AG, Zürich, Suisse.

   Durcissement par chauffage à 170°C pendant 45 minutes.

7. AT 1.

   Genre: Résine époxyde monocomposant en poudre.

   Fournisseur: Ciba-Geigy AG, Bâle, Suisse.

   Durcissement par chauffage à 180°C pendant 3 heures.

8. AV 144 + HY 997.

   Genre: Résine époxyde + durcisseur aminé.

   Mélange de résine époxyde AV 144 et de durcisseur HY 997 dans la proportion de 100 à 60 en poids.

   Fournisseur de la résine AV 144: Ciba-Geigy AG, Bâle, Suisse.

   Fournisseur du durcisseur HY 997: Ciba-Geigy AG, Bâle, Suisse.

   Durcissement par chauffage à 60°C pendant 2 heures.

9. AV 138M + HY 998.

   Genre: Résine époxyde + durcisseur aminé.

   Mélange de résine époxyde AV 138 M et de durcisseur HY 998 dans la proportion de 100 à 40 en poids.

   Fournisseur de la résine AV 138 M: Ciba-Geigy AG, Bâle, Suisse.

   Fournisseur du durcisseur HY 998: Ciba-Geigy AG, Bâle, Suisse.

Durcissement par chauffage à 60°C pendant 2 heures.

10. AY 103 + HY 951.

Genre: Résine époxyde + polyamine.

Mélange de résine époxyde AY 103 et de durcisseur HY 951 dans la proportion de 100 à 8 en poids.

Fournisseur de la résine AY 103: Ciby-Geigy AG, Bâle, Suisse.

Fournisseur du durcisseur HY 951: Ciba-Geigy AG, Bâle, Suisse.

Durcissement par chauffage à 60°C pendant 2 heures.

11. 828 EL + HHPA + TEA.

Genre: Résine époxyde + anhydride.

Mélange de résine époxyde 828 EL, de durcisseur HHPA et de durcisseur TEA dans les proportions de 100 à 80 et de 100 à 1 en poids.

Fournisseur de la résine 828 EL: Shell (Suisse), Zürich, Suisse.

Fournisseur du durcisseur HHPA: Fluka AG, Buchs (SG), Suisse.

Fournisseur du durcisseur TEA: Fluka AG, Buchs (SG), Suisse.

Durcissement par chauffage à 150°C pendant 3 à 5 heures.

12. AF 46.

Genre: Résine époxyde de formulation spéciale sous forme de film.

Fournisseur: 3M (Suisse) AG, Zürich, Suisse.

Durcissement par chauffage à 165°C pendant 30 minutes.

13. Conloc 101

Genre: Ester diméthylacrylique (anaérobique).

Fournisseur: Chimie Moudon SA, Sarnen, Suisse.

Durcissement par chauffage à 20°C pendant 12 heures.

14. Conloc 301

Genre: Ester diméthylacrylique (anaérobique).

Fournisseur: Chimie Moudon SA, Sarnen, Suisse.

Durcissement par chauffage à 20°C pendant 12 heures.

B) Adhésifs thermo-fusibles

1. Versamid 930

Genre: Polyamide.

Fournisseur: Hans Rahn & Co, Zürich, Suisse.

Déposé à 150°C environ.

2. Fana 2011

Genre: Polyester.

Fournisseur: Chemische Fabrik Neuallschwil AG, Allschwil,
Suisse.

Déposé à 130 à 150°C.

3. Bostik 9951

Genre: Ethyl-Vinyl-Acétate.

Fournisseur: Bostik GmbH, Zürich, Suisse.

Déposé à 130 à 150°C.

Les expériences faites avec ces adhésifs ont été réalisées de la manière suivante:

Deux pièces métalliques de dimensions connues présentant chacune au moins une face plane sont assemblées par une couche d'adhésif disposée entre ces deux faces planes. Après durcissement de

l'adhésif, sa résistance électrique est mesurée en reliant chacune des pièces métalliques à l'une des bornes d'un ohmmètre.

L'épaisseur de la couche d'adhésif peut être calculée en soustrayant la somme des épaisseurs des pièces métalliques de l'épaisseur totale de l'assemblage. Cette épaisseur peut également être mesurée après que la couche d'adhésif a été cassée. En effet, après cette cassure, certaines zones des pièces métalliques qui étaient en contact avec l'adhésif sont mises à nu. Il est alors possible de déterminer l'épaisseur de la couche d'adhésif en mesurant la rugosité de ces surfaces à l'aide d'un rugosimètre.

Il est encore possible de mélanger à l'adhésif, avant son dépôt, des billes ou des fibres de verre de diamètre connu, et d'exercer une certaine force sur les pièces métalliques pendant le durcissement de l'adhésif. L'épaisseur de celui-ci est alors pratiquement égale au diamètre des billes ou des fibres.

Les tableaux suivants rassemblent les résultats des expériences faites dans les conditions décrites ci-dessus.

Les tableaux 1.1 à 1.16 indiquent la variation de la résistance électrique R d'une couche d'adhésif, mesurée en ohms, en fonction de l'épaisseur e de cette couche, mesurée en micromètres, pour divers métaux, divers adhésifs et diverses sections.

Les tableaux 2.1 à 2.6 indiquent la résistance électrique R de divers adhésifs déposés sur divers métaux en couches d'épaisseur et de section déterminées.

Les tableaux 3.1 et 3.2 indiquent, chacun pour une couche d'épaisseur et de section déterminées d'un adhésif également déterminé, la résistance électrique R de cet adhésif lorsqu'il sert à assembler divers métaux.

Enfin, le tableau 4 indique la variation de la résistance électrique R d'une couche d'adhésif en fonction de sa section S, pour un adhésif, une épaisseur de la couche et un métal déterminés.

Il faut noter que la dispersion des valeurs de la résistance électrique indiquées dans les tableaux est due en grande partie à l'imprécision des mesures de l'épaisseur des couches d'adhésif.

1.    Variations de R en fonction de l'épaisseur e

1.1.   Adhésif : 828 EL + HY 951 Métal :   cuivre-cuivre

Section : 1 cm$^2$

| e (μm) | R (Ω) |
|--------|-------|
| 3 | 0,025 |
| 4 | 0,013 à 0,16 |
| 5 | 0,013 à 0,015 |
| 6 | 0,015 à 0,04 |
| 7 | 0,08 |
| 8 | 0,014 à 0,16 |
| 9 | 0,016 |
| 10 | 0,016 à 0,032 |
| 12 | 9 |
| 15 | 14 à 31,5 |
| 17 | 1,6 . 10$^5$ |

1.2.   Adhésif : 828 EL + HY 951

Métal :   étain-étain

Section : 1 mm$^2$

| e (μm) | R (Ω) |
|--------|-------|
| 2 | 0,13 à 0,2 |
| 3 | 0,16 |
| 4 | 0,12 |
| 5 | 0,06 à 0,08 |
| 6 | 0,15 à 2 |
| 13 | >1MΩ |
| 25 | >1MΩ |

1.3.    Adhésif : 828 EL + HY 951 Métal :   Or - Or

Section : 1 cm$^2$

| e (μm) | R (Ω) |
|--------|-------|
| 10 | 0,02 à 0,5 |
| 12 | 0,18 à 2,16 |
| 20 | 0,14 à 0,65 |
| 25 | 4,3 |
| 30 | 1 à 1,56 |
| 35 | 4,02 |
| 40 | 1,8 |

1.4.    Adhésif : 828 EL + HY 951 Métal :   Cuivre au Beryllium - Cuivre au Beryllium

Section : 1 cm$^2$

| e (μm) | R (Ω) |
|--------|-------|
| 5 | 0,016 |
| 8 | 0,01 à 0,06 |
| 10 | 0,011 à 0,06 |
| 11 | 0,25 |
| 17 | 1,8 |

1.5.    Adhésif : 828 EL + HY 951 Métal :   Acier - Acier

Section : 1 cm$^2$

| e (μm) | R (Ω) |
|--------|-------|
| 5 | 0,01 à 0,016 |
| 6 | 0,02 |
| 8 | 0,05 à 0,88 |
| 10 | $>10^6$ |

0131737

1.6.    Adhésif : 828 EL + HY 951 Métal :    Aluminium - Aluminium

Section : 1 cm$^2$

| e (um) | R ($\Omega$) |
|--------|--------------|
| 5 | 0,14 à 1,25 |
| 6 | 0,16 |
| 7 | 1 à 13 |
| 8 | 20 |
| 10 | 0,032 à $10^6$ |
| $\geqq$12 | >$10^6$ |

1.7.    Adhésif : 828 EL + HY 951 Métal :    Laiton - Laiton

Section : 1 cm$^2$

| e ($\mu$m) | R ($\Omega$) |
|------------|--------------|
| 3 | 0,011 |
| 4 | 0,011 à 0,016 |
| 6 | 0,016 |
| 10 | 0,016 à 0,16 |
| 11 | 0,016 |
| 12 | 0,16 |
| 14 | 2,5 |
| 17 | >$10^6$ |

1.8.   Adhésif : AV 118 Métal :   Cuivre-Cuivre

Section : 1 cm$^2$

| e (μm) | R (Ω) |
|--------|-------|
| 3 | 0,013 |
| 4 | 0,011 |
| 5 | 0,01 |
| 6 | 0,01 |
| 10 | 0,013 |
| 15 | 0,014 |
| 20 | 0,16 à 0,2 |
| 25 | 20 à 26 |
| 30 | >10$^6$ |

1.9.   Adhésif : AV 118 Métal :   Laiton-Laiton

Section : 1 cm$^2$

| e (μm) | R (Ω) |
|--------|-------|
| 5 | 0,013 |
| 10 | 0,011 |
| 15 | 0,01 à 0,014 |
| 20 | 0,011 |
| 30 | >10$^6$ |

1.10.   Adhésif : AV 118 Métal :   Acier-Acier

Section : 1 cm$^2$

| e (µm) | R (Ω) |
|---|---|
| 3,5 | 0,01 |
| 8,5 | 0,011 |
| 18 | 0,18 à 0,25 |
| 22 | 18 à 22 |

1.11.   Adhésif : AV 118 Métal :   Aluminium-Aluminium

Section : 1 cm$^2$

| e (µm) | R (Ω) |
|---|---|
| 2 | 0,013 |
| 3 | 0,01 |
| 15 | 1,1 à 1,2 |
| 18 | 1,25 à 1,4 |
| 30 | $>10^6$ |

1.12.   Adhésif : AV 118 Métal :   Cuivre au Beryllium-Cuivre au Beryllium

Section : 1 cm$^2$

| e (µm) | R (Ω) |
|---|---|
| 2,5 | 0,01 |
| 4,5 | 0,01 |
| 6 | 0,01 |
| 25 | $>10^6$ |

1.13.  Adhésif : AV 118 Métal :   Or-Or

Section : 1 cm$^2$

| e (μm) | R (Ω) |
|---|---|
| 2 | 0,01 |
| 8 | 0,011 |
| 15 | 0,01 à 0,013 |
| 35 | >10$^6$ |

1.14.  Adhésif : Versamid 930 Métal :   Cuivre-Cuivre

Section : 1 cm$^2$

| e (μm) | R (Ω) |
|---|---|
| 2 | 0,025 |
| 3 | 0,025 à 0,05 |
| 4 | 0,025 à 0,13 |
| 5 | 2 |
| 6 | 2 |
| 7 | >10$^6$ |

1.15.  Adhésif : Fana 2011 Métal :   Cuivre-Cuivre

Section : 1 cm$^2$

| e (μm) | R (Ω) |
|---|---|
| 2 | 0,02 |
| 3 | 0,02 à 0,06 |
| 3,5 | 1,26 à 3,16 |
| 4 | 31,6 |
| 6 | >10$^6$ |

0131737

1.16.    Adhésif : Bostik 9951 Métal :    Cuivre-Cuivre

Section : 1 cm$^2$

| e (μm) | R (Ω) |
|--------|-------|
| 2 | 0,016 à 0,025 |
| 2,5 | 0,16 à 0,4 |
| 3 | 0,16 à 0,63 |
| 3,25 | 1,6 |
| 4 | $>10^6$ |

2.    <u>Variations de R en fonction de l'adhésif utilisé</u>

2.1.    Métal :    Laiton-Laiton

Section : 20 mm$^2$

Epaisseur:10μm

| Adhésif | R (Ω) |
|---------|-------|
| EC 1386 | 0,23 |
| AT 1 | 0,09 à 0,3 |
| AV 144 + HY 997 | 0,07 à 0,2 |
| AV 138M + HY 998 | 0,08 à 0,2 |
| AF 46 | 0,13 à 0,2 |
| Engelhardt 46-12 | 0,1 à 25,7 |
| Fana PUR 1 | 0,25 à 10 |
| Conloc 301 | 0,2 |
| Conloc 101 | 0,2 |
| Cyanolite 401 | 0,17 à 0,2 |
| 828 EL + HY 951 | 0,08 à 0,8 |
| AV 118 | 0,01 à 0,055 |
| AY 103 + HY 951 | 0,03 à 0,04 |

2.2.   Métal :   Cuivre-Cuivre

Section : 1 cm$^2$

Epaisseur:5μm

| Adhésif | R (Ω) |
|---|---|
| 828 EL + HY 951 | 0,013 |
| Versamid 930 | 0,03 à 2 |
| Fana 2011 | 0,03 à 39,5 |
| Bostik 9951 | 0,04 à 2,5 |
| AV 118 | 0,01 |

2.3.   Métal :   Or-Or

Section : 1 cm$^2$

Epaisseur:10μm

| Adhésif | R (Ω) |
|---|---|
| 828 EL + HY 951 | 0,02 à 1,8 |
| AV 118 | 0,01 à 0,05 |
| 828 EL + HHPA + TEA | 0,01 |

2.4.   Métal :   Acier-Acier

Section : 1 cm$^2$

Epaisseur:5μm

| Adhésif | R (Ω) |
|---|---|
| 828 EL + HY 951 | 0,01 à 0,017 |
| AV 118 | 0,014 à 0,07 |

2.5.   Métal :   Aluminium-Aluminium

Section : 1 cm$^2$

Epaisseur:5μm

| Adhésif | R (Ω) |
|---|---|
| 828 EL + HY 951 | 0,02 à 12,5 |
| AV 118 | 0,02 à 0,4 |

2.6.   Métal :   Cuivre au Beryllium-Cuivre au Beryllium

Section : 1 cm$^2$

Epaisseur:10μm

| Adhésif | R (Ω) |
|---|---|
| 828 EL + HY 951 | 0,01 à 0,3 |
| AV 118 | 0,017 à 0,04 |

3.   Variations de R en fonction du matériau conducteur

3.1.   Adhésif : 828 EL + HY 951

Section : 1 cm$^2$

Epaisseur:10μm

| Métal | R (Ω) |
|---|---|
| Cuivre | 0,016 à 7,5 |
| Etain | 0,001 à 0,03 |
| Or | 0,02 à 1,8 |
| Titane | 0,52 |
| Indium | 0,03 |
| Plomb | 0,03 |
| Cuivre au Beryllium | 0,013 à 0,3 |
| Acier | 0,02 à 1,1 |
| Aluminium | 0,03 à 18,5 |

28 0131737

3.2. Adhésif : AV 118

Section : 1 cm$^2$

Epaisseur:10µm

| Métal | R ($\Omega$) |
|---|---|
| Or | 0,01 à 0,05 |
| Cuivre | 0,013 à 10,4 |
| Laiton | 0,005 à 0,026 |
| Aluminium | 0,033 à 0,8 |
| Acier | 0,013 à 10 |
| Cuivre au Beryllium | 0,016 à 0,04 |

4. <u>Variation de R en fonction de la section S de l'adhésif</u>

Adhésif : 828EL + HY 951

Métal : Or

Epaisseur:10µm

| S (mm$^2$) | R ($\Omega$) |
|---|---|
| 6 | 1,2 |
| 10 | 3,25 à 3,67 |
| 12 | 1,25 à 4,33 |
| 20 | 2,56 |
| 26 | 1,76 |
| 120 | 0,96 |
| 200 | 0,86 |
| 240 | 0,75 |
| 360 | 0,13 |

REVENDICATIONS

1. Procédé pour connecter électriquement un premier et un deuxième conducteur, caractérisé par le fait qu'il consiste à déposer au moins sur le premier conducteur (4) une couche d'un matériau adhésif (9) non conducteur, à disposer le deuxième conducteur (6) contre ladite couche en regard du premier conducteur (4), et à rapprocher lesdits conducteurs (4, 6) l'un de l'autre alors que ledit matériau (9) est dans son état liquide ou pâteux jusqu'à ce que l'épaisseur de ladite couche entre lesdits conducteurs (4,6) prenne une valeur pour laquelle ledit matériau (9) est électriquement conducteur dans son état solide.

2. Procédé selon la revendication 1, caractérisé par le fait que ledit matériau (9) fait partie de la classe des adhésifs de réaction.

3. Procédé selon la revendicaton 1, caractérisé par le fait que ledit matériau (9) fait partie de la classe des adhésifs thermofusibles.

4. Procédé selon l'une des revendications 2 et 3, caractérisé par le fait qu'il consiste à déposer ladite couche alors que ledit matériau (9) est dans son état liquide ou pâteux.

5. Procédé selon la revendication 3, caractérisé par le fait qu'il consiste à déposer ladite couche alors que ledit matériau (9) est dans son état solide et, en outre, à chauffer ledit matériau (9) après avoir disposé le deuxième conducteur (6) en regard du premier conducteur (4), jusqu'à ce que ledit matériau (9) prenne son état liquide.

6. Procédé selon la revendication 1, caractérisé par le fait que ladite valeur est inférieure à 50 micromètres.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| A | EP-A-0 068 793 (ITT) <br> * Résumé; figures * <br><br> ----- | 1 | H 01 R 4/04 <br> H 05 K 3/32 |

DOMAINES TECHNIQUES RECHERCHES (Int. Cl. 3)

H 01 R
H 05 K

Le présent rapport de recherche a été établi pour toutes les revendications

| Lieu de la recherche | Date d'achèvement de la recherche | Examinateur |
|---|---|---|
| LA HAYE | 19-07-1984 | RAMBOER P. |